# EUROPÄISCHE PATENTANMELDUNG

(11) **EP 0 856 595 A2**
(43) Veröffentlichungstag der Anmeldung: **05.08.1998**
(21) Anmeldenummer: 98101070.5
(22) Anmeldetag: 22.01.1998
(51) Int. Cl.: C23C 16/44, H01L 21/00, B08B 5/00

(54) **Verfahren zum Entfernen silicumhaltiger Beschichtungen**

(30) Priorität: 29.01.1997 DE 19703204
(71) Anmelder: SIEMENS AKTIENGESELLSCHAFT, 80333 München (DE)
(72) Erfinder: Eichinger, Andreas, 93055 Regensburg (DE); Schmalzbauer, Klaus, Dr., 93186 Pettendorf (DE)

(57) **Zusammenfassung**

Die Erfindung betrifft ein Verfahren zum Entfernen siliciumhaltiger Beschichtungen von einem Gegenstand und insbesondere einem Ofenboot, welches bei einem LPCVD-Prozeß zum Halten der zu beschichtenden Wafer verwendet wurde. Erfindungsgemäß wird die siliciumhaltige Beschichtung durch Plasmaätzen mit einem Ätzmittel entfernt, welches Sauerstoff und wenigstens eine fluorhaltige Verbindung umfaßt. Bevorzugte fluorhaltige Verbindungen sind fluorierte Kohlenwasserstoffe wie insbesondere Tetrafluorkohlenstoff. Ein bevorzugtes Ätzmittel besteht aus Tetrafluorkohlenstoff und Sauerstoff. Das erfindungsgemäße Reinigungsverfahren greift die Ofenboote sehr viel weniger an als die üblichen naßchemischen Reinigungen. Wegen der geringen Schädigung der Ofenboote durch das erfindungsgemäße Verfahren wird die Lebenszeit der Ofenboote erheblich verlängert.

## Beschreibung

Die Erfindung betrifft ein Verfahren zum Entfernen siliciumhaltiger Beschichtungen von einem Gegenstand und insbesondere von einem Ofenboot. Ofenboote oder Quartzhorte dienen bei der Bearbeitung von Halbleiter-Wafern als Halter oder Ständer für die Wafer, wenn diese mit einer Beschichtung versehen werden sollen. Derartige Ofenboote bestehen häufig aus Quartz oder Siliciumkarbid. Sie weisen im allgemeinen eine Vielzahl paralleler Schlitze auf, in die die Wafer eingestellt werden. Die Beschichtung der Wafer erfolgt üblicherweise durch einen LPCVD-Prozeß (LPCVD = Low Pressure Chemical Wafer Deposition). Die abgeschiedenen Schichten bestehen meist aus Siliciumnitrid, Polysilicium oder deren Gemischen. Das Beschichtungsmaterial scheidet sich bei der Beschichtung nicht nur auf den Wafern ab, sondern auch auf den Ofenbooten und muß nach einigen Beschichtungsdurchläufen von diesen entfernt werden.

Bislang wird hierfür üblicherweise ein naßchemisches Reinigungsverfahren verwendet, das beispielsweise eine Mischung aus Fluorwasserstoff, Salpetersäure und Wasser zum Ätzen der abgelagerten, einige µm dicken Schicht benutzt. Um diese Schicht vollständig zu entfernen, muß im allgemeinen relativ lange überätzt werden. Dabei besteht die Gefahr, in den Bereichen, in denen eine dünnere Schicht abgelagert wurde - zum Beispiel im Bereich der Schlitze zur Waferaufnahme - , das Boot selbst anzuätzen. In der Regel werden bei der naßchemischen Reinigung 20 bis 100 µm der Bootoberfläche abgetragen. Dadurch wird einerseits die Maßhaltigkeit des Bootes beeinträchtigt und andererseits die Bootoberfläche stark aufgerauht. Diese Rauhigkeit kann zwar durch Überflammen in gewissem Maße geglättet werden, wobei das Quarzmaterial oberflächlich verfließt, und dadurch kann die Lebensdauer des Bootes` verlängert werden. Dennoch ist es gerade bei teueren Wafern in der Chipfertigung üblich, um diese nicht zu gefährden, die Boote nach wenigen (in der Regel zwei bis fünf) Reinigungsoder Überflammvorgängen zu verwerfen.

Ein weiterer Nachteil des naßchemischen Reinigens besteht darin, daß gelegentlich Restfeuchtigkeit oder nicht vollständig weggeätzte Restschichtbestände auf den Booten haften bleiben. Dies führt dazu, daß in weiteren Beschichtungsvorgängen das abgelagerte Beschichtungsmaterial auf dem Boot nicht hinreichend haftet, abplatzt und die Beschichtungskammer und die darin befindlichen Wafer verunreinigt, wodurch sich der Ausschuß erhöht.

Wegen des hohen Verschleißes an Ofenbooten, zusätzlicher Verfahrensschritte zur Glättung der Boote und der möglichen Gefährdung nachfolgender Beschichtungsvorgänge ist die naßchemische Reinigung von Ofenbooten zeitaufwendig und teuer.

Aufgabe der Erfindung ist es, ein Verfahren zur Reinigung von Gegenständen und insbesondere Ofenbooten von Beschichtungsrückständen anzugeben, welches einfach und kostengünstig durchführbar und so steuerbar ist, daß die Beschädigung der Gegenstände weitestgehend vermieden und ihre Lebensdauer und Einsatzfähigkeit verlängert wird.

Die Lösung der Aufgabe gelingt mit dem Verfahren gemäß Anspruch 1. Vorteilhafte Merkmale des Verfahrens sind den Unteransprüchen zu entnehmen.

Das erfindungsgemäße Verfahren betrifft also ein Verfahren zum Entfernen siliciumhaltiger Beschichtungen aus einem LPCVD-Prozeß von einem Ofenboot oder ganz allgemein Gegenständen, die während eines LPCVD-Prozesses mit siliciumhaltiger Beschichtung verunreinigt wurden, mit Hilfe des Plasmaätzens, bei dem ein Ätzmittel eingesetzt wird, welches Sauer stoff und wenigstens eine fluorhaltige Verbindung umfaßt. Als fluorhaltige Verbindung können ein oder mehrere Fluorkohlenwasserstoffe wie CF₄ , CHF₃ , C₂F₆ usw., SF₆ , SiF₄ oder NF₃ verwendet werden. Eine bevorzugte fluorhaltige Verbindung ist CF₄ , ein bevorzugtes Ätzmittel besteht aus CF₄ , O₂ und N₂. Die Zusammensetzung des Ätzmittels sowie die Konzentration der Verbindungen im Ätzmittel, welche die eigentliche Ätzwirkung entfalten - im letztgenannten Fall sind dies CF₄ und O₂ -und ihr Konzentrationsverhältnis untereinander werden zweckmäßig in Abhängigkeit von der Art und Dicke der zu ätzenden Beschichtung auf dem zu reinigenden Gegenstand ausgewählt.

Vorteilhaft kann es beispielsweise sein, die Konzentration der einzelnen Komponenten des Ätzmittels im Verlauf des Ätzverfahrens zu ändern. Die Änderung kann dabei kontinuierlich oder stufenweise erfolgen. Um zu vermeiden, daß das Ofenboot (das im folgenden beispielhaft für alle zu reinigenden Gegenstände stehen soll) durch das Ätzmittel zu stark angegriffen wird, ist es im allgemeinen von Vorteil, die Konzentration der Verbindungen, die die Ätzwirkung entfalten (im folgenden Ätzverbindungen) im Ätzmittel im Verlauf des Ätzvorgangs zu senken. Zu Beginn des Ätzvorgangs ist die Konzentration der Ätzverbindungen im Plasma also relativ hoch, um einen Großteil der zu ätzenden Beschichtung schnell abzuätzen. Dann wird die Konzentration der Ätzverbindungen im Plasma vermindert, um das Abtragen von Bootmaterial möglichst zu verhindern.

Geätzt werden können grundsätzlich, sieht man einmal von Siliciumdioxid ab, alle siliciumhaltigen Beschichtungen, die während eines LPCVD-Prozesses auf einem Ofenboot abgeschieden wurden. Im Rahmen der Halbleiterfertigung sind dies in der Regel Beschichtungen, die im wesentlichen aus Siliciumnitrid, Polysilicium oder deren Mischungen bestehen. Unter Polysilicium ist in diesem Zusammenhang sowohl Polysilicium zu verstehen, das mit Metallen wie beispielsweise Bor, Phosphor, Arsen oder Antimon dotiert ist, als auch undotiertes Polysilicium.

Im erfindungsgemäßen Verfahren können die üblicherweise verwendeten Boote eingesetzt werden, die im allgemeinen aus Siliciumcarbid oder Quarz bestehen. Grundsätzlich können alle Gegenstände gereinigt werden, die durch das erfindungsgemäße Reinigungsverfahren nicht zu stark angegriffen werden.

Das erfindungsgemäße Verfahren kann in jeder üblichen Plasmaätzvorrichtung durchgeführt werden. Eine bevorzugte Vorrichtung entspricht im wesentlichen handelsüblichen Veraschern, wie sie beispielsweise von den Firmen Branson, Tepla und IPC erhältlich sind. Um auch sogenannte Langboote bearbeiten zu können, ist jedoch zweckmäßig die Ätzkammer vergrößert, um auch diesen Booten Platz zu bieten.

Die üblicherweise verwendete Verfahrenstemperatur liegt im Bereich zwischen Raumtemperatur und etwa 70°C. Zweckmäßig wird dem eigentlichen Ätzvorgang ein Temperatureinstellschritt vorgeschaltet, bei welchem die Ätzkammer auf eine geeignete Anfangstemperatur eingestellt wird. Vorteilhaft ist dabei die Kammer mit Stickstoff befüllt. Eine geeignete Anfangstemperatur liegt beispielsweise im Bereich von 40°C. Die genauen Anfangs- uns Verfahrenstemperaturen hängen unter anderem von der Art des zu bearbeitenden Ofenbootes, der zu ätzenden Beschichtung, der Ätzvorrichtung und dem Ätzmittel ab. Es kann zum Erreichen gleichmäßiger Ätzresultate zweckmäßig sein, die Temperatur in der Ätzkammer lokal zu regeln. Dies kann auf an sich bekannte Weise über die Mikrowellenleistung einzelner, über die Ätzkammer verteilter Mikrowellengeneratoren mit einer Leistung von üblicherweise 200 bis 100 Watt erfolgen.
Der Prozeßdruck wird im allgemeinen zwischen 10 und 5000 mTorr liegen.

Auch die Konzentration der Ätzverbindungen in der Kammer kann lokal variiert werden. Beispielsweise kann dies erreicht werden, indem in der Kammer mehrere Zuleitungen für das Ätzgas vorgesehen sind. Im Mündungsbereich dieser Gasinjektoren ist die Konzentration des Ätzmittels besonders hoch, während die Konzentration mit zunehmender Entfernung vom Auslaß der Zu-leitungen abnimmt. Es ist also möglich, durch gezielte Ausrichtung der Gasinjektoren in bestimmten Bereichen der Kammer lokal höhere Konzentrationen an Ätzmittel einzustellen als in anderen Bereichen. Beispielsweise kann die lokale Ätzmittelkonzentration in Abhängigkeit von der jeweils in vorgegebenen Bereichen angetroffenen Schichtdicke der zu ätzenden Beschichtung gewählt werden. Wo die zu ätzende Beschichtung auf dem Boot besonders dick ist, kann zweckmäßig eine höhere Ätzmittelkonzentration eingestellt werden.

Durch Änderung der Temperatur und des Prozeßdrucks sowie geeignete Wahl des Ätzmittels und dessen Konzentration kann die Ätzrate, gegebenenfalls auch lokal und zeitlich, variiert werden. Eine geeignete Ätzrate liegt im Bereich von 10 bis 200 nm/min.

Im Anschluß an den Ätzvorgang folgt zweckmäßig ein Spülschritt, in welchem das Ätzmittel aus der Kammer entfernt wird. Dies kann zum Beispiel durch Hindurchleiten von Stickstoff durch die Kammer geschehen.

Ein möglicher Verfahrensablauf des erfindungsgemäßen Reinigungsverfahrens könnte beispielsweise wie folgt aussehen. Ein zu reinigendes Ofenboot, das von einer Beschichtung befreit werden soll, die zum Beispiel aus Siliciumnitrid und Polysilicium besteht, wird in der Kammer einer herkömmlichen Ätzvorrichtung mit einer zur Aufnahme des Bootes geeigneten Größe plaziert. Es folgt ein Temperatureinstellschritt, bei welchem die Kammer mit Stickstoff gefüllt ist, der mit einer Fließgeschwindigkeit von 10 bis 50 sccm (Standard-Kubikzentimeter pro Minute) eingeleitet wird. Die Zufuhrrate dieses und der nachfolgend genannten Gase richtet sich - außer nach den bereits angesprochenen Parametern - insbesondere nach der Kammergröße und der Pumpleistung der Zufuhrvorrichtung. Je nach Starttemperatur dauert diese Phase 10 bis 60 Minuten. Nun schließt sich der eigentliche Ätzvorgang an, der beispielsweise in zwei Stufen durchgeführt wird. In der ersten Stufe werden der Kammer zusätzlich zum oder an Stelle von Stickstoff oder an Stelle des Stickstoffs Sauerstoff und Tetrafluorkohlenstoff als Ätzverbindungen zugeführt. Je nach Schichtdicke und Zusammensetzung der zu ätzenden Schicht dauert diese Stufe in der Regel 20 bis 90 Minuten. Der Gasfluß für Sauerstoff kann zweckmäßig 100 bis 200 sccm, der für CF₄ 100 bis 400 sccm betragen. In dieser ersten Ätzstufe wird ein Großteil der Schicht weggeätzt.
In der anschließenden zweiten Ätzstufe wird die Konzentration der Ätzverbindungen in der Kammer reduziert. Beispielsweise beträgt der Gasfluß für Sauerstoff und Tetrafluorkohlenstoff jeweils 10 bis 100 sccm. Die Dauer des zweiten Ätzschrittes wird von den gleichen Parametern bestimmt wie der erste Ätzschritt und liegt im allgemeinen zwischen 40 und 150 Minuten.

Anschließend wird die Kammer einige Minuten mit Stickstoff gespült, ohne daß ein Plasma erzeugt wird. Dann wird das gereinigte Ofenboot aus der Kammer entfernt.

Gegenüber den naßchemischen Reinigungsverfahren des Standes der Technik besitzt das erfindungsgemäße Verfahren einige Vorteile. Zum einen wird selbst bei längerem Überätzen nur sehr wenig Bootmaterial abgetragen, in der Regel nur etwa 0,5 bis 2 µm, während beim naßchemischen Ätzen üblicherweise 20 bis 100 µm Bootmaterial verloren gehen. Entsprechend ist die Aufrauhung der Bootoberfläche durch das erfindungsgemäße Verfahren sehr viel geringer, und ein Überflammvorgang zur Oberflächenglättung ist nicht erforderlich. Durch die geringe Schädigung des Ofenboots bleibt die Maßhaltigkeit des Bootes über einen sehr viel längeren Zeitraum erhalten, und die erfindungsgemäß gereinigten Ofenboote können 5-50 Mal länger genutzt werden als die herkömmlich gereinigten. Das eingangs angesprochene Problem beim naßchemischen Reinigen, daß durch Restfeuchte oder nicht weggeätzte Beschichtungen bei nachfolgenden Beschichtungsvorgängen Haftungsprobleme auftreten, die dazu führen, daß abgeplatzte Beschichtung zur Verunreinigung der Ätzvorrichtung und der zu beschichtenden Wafer führt, tritt bei erfindungsgemäß gereinigten Booten nicht auf. Das erfindungsgemäße Verfahren ist also nicht nur kostengünstiger, sondern auch sicherer als die übliche naßchemische Reinigung von Ofenbooten.

## Patentansprüche

1. Verfahren zum Entfernen siliciumhaltiger Beschichtungen aus einem LPCVD-Prozeß von einem Gegenstand,
**dadurch gekennzeichnet**,
daß die siliciumhaltige Beschichtung durch Plasmaätzen mit einem Ätzmittel entfernt wird, welches Sauerstoff und wenigstens eine fluorhaltige Verbindung umfaßt.

2. Verfahren gemäß Anspruch 1,
**dadurch gekennzeichnet**,
daß als fluorhaltige Verbindung SF₆ , SiF₄ , NF₃ , ein fluorhaltiger Kohlenwasserstoff oder eine Mischung wenigstens zweier dieser Verbindungen eingesetzt wird.

3. Verfahren gemäß Anspruch 2,
**dadurch gekennzeichnet**,
daß als fluorierter Kohlenwasserstoff CF₄ eingesetzt wird.

4. Verfahren gemäß einem der Ansprüche 1 bis 3,
**dadurch gekennzeichnet**,
daß das Ätzmittel aus CF₄ , O₂ und gegebenenfalls N₂ besteht.

5. Verfahren gemäß einem der Anspruch 1 bis 4,
**dadurch gekennzeichnet**,
daß die Konzentration der einzelnen Komponenten des Ätzmittels in der Ätzvorrichtung im Verlauf des Ätzvorgangs geändert wird.

6. Verfahren gemäß Anspruch 5,
**dadurch gekennzeichnet**,
daß die Konzentration der Ätzverbindungen im Verlauf des Ätzvorgangs gesenkt wird.

7. Verfahren gemäß einem der Ansprüche 1 bis 6,
**dadurch gekennzeichnet**,
daß die Zufuhr der fluorhaltigen Verbindung zur Ätzvorrichtung im Anfangsstadium des Ätzvorgangs im Bereich von 100 bis 400 sccm und im Endstadium von 10 bis 100 sccm liegt.

8. Verfahren gemäß einem der Ansprüche 1 bis 7,
**dadurch gekennzeichnet**,
daß die Zufuhr des Sauerstoffs zur Ätzvorrichtung im Anfangsstadium des Ätzvorgangs im Bereich von 100 bis 200 sccm und im Endstadium von 10 bis 100 sccm liegt.

9. Verfahren gemäß einem der Ansprüche 1 bis 8,
**dadurch gekennzeichnet**,
daß die Konzentration des Ätzmittels in der Ätzvorrichtung lokal variiert wird.

10. Verfahren gemäß einem der Ansprüche 1 bis 9,
**dadurch gekennzeichnet**,
daß dem Ätzvorgang eine Temperatureinstellstufe vorgeschaltet ist.

11. Verfahren gemäß einem der Ansprüche 1 bis 10,
**dadurch gekennzeichnet**,
daß dem Ätzvorgang ein Spülschritt nachgeschaltet ist.

12. Verfahren gemäß einem der Ansprüche 1 bis 11,
**dadurch gekennzeichnet**,
daß die Temperatur im Bereich zwischen Raumtemperatur und 70 °C liegt.

13. Verfahren gemäß Anspruch 12,
**dadurch gekennzeichnet**,
daß die Temperatur in der Ätzvorrichtung lokal variiert wird.

14. Verfahren gemäß einem der Ansprüche 1 bis 13,
**dadurch gekennzeichnet**,
daß der Druck im Bereich von 10 bis 5000 mTorr liegt.

15. Verfahren gemäß einem der Ansprüche 1 bis 14,
**dadurch gekennzeichnet**,
daß die zu entfernende siliciumhaltige Beschichtung im wesentlichen aus dotiertem oder undotiertem Polysilicium und/oder Siliciumnitrid besteht.

16. Verfahren gemäß einem der Ansprüche 1 bis 15,
**dadurch gekennzeichnet**,
daß der zu reinigende Gegenstand ein Ofenboot ist.

17. Verfahren gemäß einem der Ansprüche 1 bis 16,
**dadurch gekennzeichnet**,
daß der zu reinigende Gegenstand aus Quarz oder Siliciumcarbid besteht.
